Europäisches Patentamt

European Patent Office

Office européen des brevets

(11) Veröffentlichungsnummer: **0 305 555**
**A1**

(12) # EUROPÄISCHE PATENTANMELDUNG

(21) Anmeldenummer: 87112510.0

(51) Int. Cl.⁴: **H04B 1/08 , B60R 11/02 , H05K 11/02**

(22) Anmeldetag: **28.08.87**

(43) Veröffentlichungstag der Anmeldung:
**08.03.89 Patentblatt 89/10**

(84) Benannte Vertragsstaaten:
**AT BE CH DE ES FR GB GR IT LI LU NL SE**

(71) Anmelder: **Blaupunkt-Werke GmbH**
**Robert-Bosch-Strasse 200**
**D-3200 Hildesheim(DE)**

(72) Erfinder: **Kitabayashi, Shinichi**
**903. Seishin 1.4.5 Edogawa-Ku**
**Tokyo(JP)**

(74) Vertreter: **Eilers, Norbert, Dipl.-Phys.**
**Blaupunkt-Werke GmbH**
**Robert-Bosch-Strasse 200**
**D-3200 Hildesheim(DE)**

(54) **Bedienteil für ein Autoradio.**

(57) Zum Schutz gegen Diebstahl des Autoradios ist das Bedienteil getrennt von dem Autoradio im Kraftfahrzeug leicht lösbar befestigt.

Fig. 3

## Bedienteil für ein Autoradio

Die Erfindung betrifft ein Bedienteil nach der Gattung des Hauptanspruchs.

Autoradios werden üblicherweise in jeweils einen Ausschnitt im Armaturenbrett eines Kraftfahrzeugs eingesetzt, wobei die sichtbare Fläche des Autoradios zur Aufnahme von Bedien- und Anzeigeelementen genutzt wird. Dabei unterliegt die Wahl des Einbauortes des Autoradios verschiedenen Gesichtspunkten, wobei es wünschenswert ist, ein Autoradio derart einzubauen, daß die Bedienelemente in der Nähe des Lenkrades liegen. Bei einem bekannten Autoradio wird eine günstige Lage der Bedienelemente dadurch ermöglicht, daß die Bedien- und Anzeigeelemente in einem getrennten Bedienteil zusammengefaßt sind, welches an einem Schwanenhals angeordnet ist. Dadurch können die Insassen eines Kraftfahrzeugs, insbesondere der Fahrer, das Bedienteil in eine griffgünstige Lage bringen. Am Autoradio selbst sind dann keine Bedienelemente mehr erforderlich, so daß es an einer nicht von außen sichtbaren Stelle des Kraftfahrzeugs eingebaut werden kann, was eine Erhöhung der Sicherheit vor Diebstahl bedeutet. Dabei ist das Bedienteil mit dem Schwanenhals diebstahlsicher verschraubt.

Ausgehend von dem bekannten Autoradio ist die Aufgabe der vorliegenden Erfindung, einen Diebstahl des Bedienteils in einfacher Weise zu verhindern, ohne daß die Gefahr von Beschädigungen bei einem gewaltsamen Diebstahl bzw. Diebstahlversuch besteht.

Das erfindungsgemäße Bedienteil mit den kennzeichnenden Merkmalen des Hauptanspruchs hat den Vorteil, daß es vom Fahrer des Fahrzeugs leicht mitgenommen werden kann.

Durch die in den Unteransprüchen aufgeführten Maßnahmen sind vorteilhafte Weiterbildungen und Verbesserungen der im Hauptanspruch angegebenen Erfindung möglich. Insbesondere tragen Weiterbildungen dazu bei, daß das Bedienteil leicht abgenommen und leicht befestigt werden kann und trotzdem eine zuverlässige Verbindung zwischen dem Bedienteil und einem Anschlußteil gegeben ist.

Besonders vorteilhaft sind dabei Ausgestaltungen der elektrischen Verbindungselemente zwischen dem Bedienteil und dem Anschlußteil, welche einerseits einen zuverlässigen elektrischen Kontakt des Bedienteils mit dem Anschlußteil bewirken und andererseits bei abgenommenem Bedienteil vor Beschädigungen und Verschmutzungen geschützt sind.

Andere Weiterbildungen bewirken, daß das Bedienteil auch im abgenommenen Zustand keine unnötigen Kanten und Vorsprünge aufweist, welche beispielsweise beim Aufbewahren des Bedienteils in einer Tasche eines Kleidungsstücks dieses beschädigen könnten und daß dabei elektrische Kontakte des Bedienteils nicht beschädigt oder verschmutzt werden.

Das erfindungsgemäße Bedienteil kann gemäß einer anderen Weiterbildung derart ausgestaltet sein, daß das Anschlußteil auf einem Schwanenhals angeordnet ist. Es ist aber auch eine Befestigung des Anschlußteils an anderen im Fahrzeug vorgesehenen Teilen, beispielsweise dem Armaturenbrett oder auf dem Pralltopf des Lenkrades, möglich.

Ausführungsbeispiele der Erfindung sind in der Zeichnung anhand mehrerer Figuren dargestellt und in der nachfolgenden Beschreibung näher erläutert. Es zeigt:

Fig. 1 ein Anschlußteil in zwei Ansichten,

Fig. 2 ein Bedienteil in zwei Ansichten und

Fig. 3 teilweise im Schnitt Seitenansichten des Anschlußteils und des Bedienteils.

Gleiche Teile sind in den Figuren mit gleichen Bezugszeichen versehen.

Das Gehäuse des Anschlußteils 1 besteht aus zwei Gehäuseteilen 2, 3, wobei am Gehäuseteil 2 in an sich bekannter Weise ein Anschluß 4 für einen Schwanenhals 5 vorgesehen ist. Die Gehäuseteile 2, 3 wer den von versenkt angeordneten Schrauben 6, 7 zusammengehalten. Zwei Schienen 8, 9, welche einstückig mit dem Gehäuseteil 2 verbunden sind, bilden die zum Anschlußteil 1 gehörenden Teile einer Schwalbenschwanzführung und sind entsprechend mit Hinterschneidungen 10, 11 versehen. Zum besseren Gleiten in den später zu erläuternden Nuten des Bedienteils sind die Schienen 8 und 9 an ihren Endbereichen 12, 13, 14, 15 etwas erhaben ausgestaltet. Im Endbereich 12 der Schiene 8 befindet sich im Gehäuseteil 2 des Anschlußteils 1 ein Ausbruch 16, durch welchen ein Betätigungselement 17 eines im übrigen nicht dargestellten Schalters hindurchragt. Der Schalter dient dazu, das Autoradio unabhängig vom jeweiligen Schaltzustand des Bedienteils beim Entfernen des Bedienteils abzuschalten.

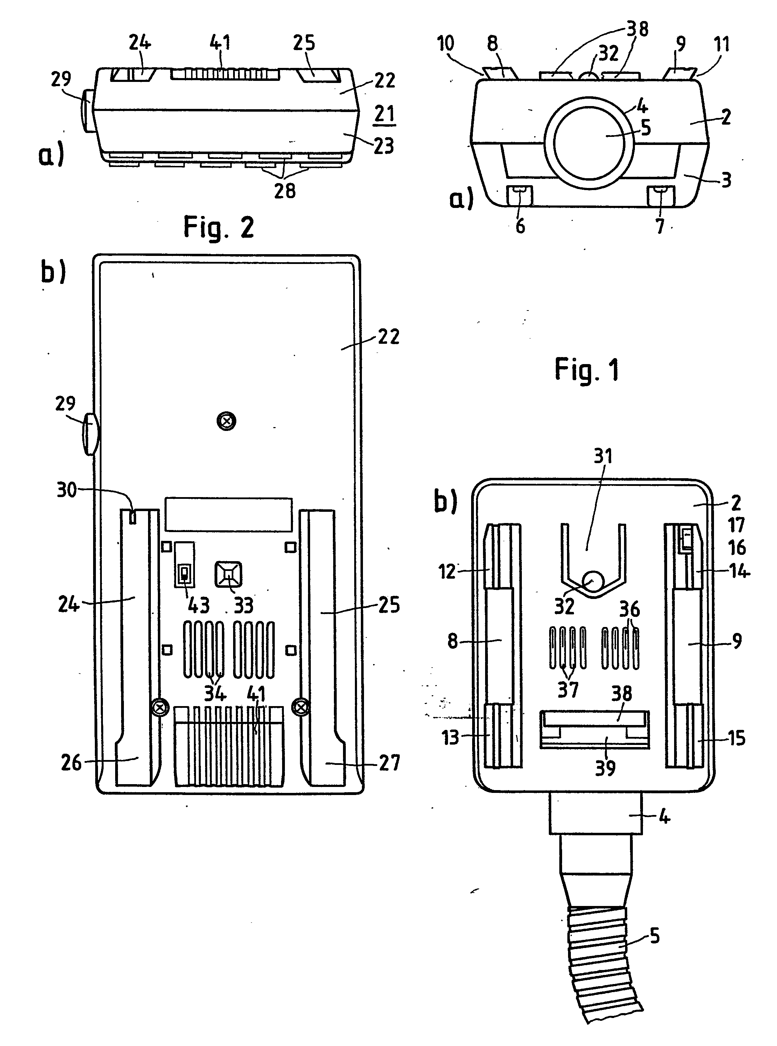

Die Schienen 8, 9 sind ferner an ihren Endbereichen 12, 14 etwas abgeschrägt, um ein Aufsetzen des Bedienteils zu erleichtern. Vor einem Eingehen auf weitere Einzelheiten des Anschlußteils 1 wird anhand von Fig. 2 das Bedienteil 21 näher erläutert. Das Gehäuse des Bedienteils 21 besteht ebenfalls aus zwei Teilen 22, 23. In das Gehäuseteil 22 sind zwei Nuten 24, 25 eingeformt, deren Profil an die Schienen 8, 9 des Anschlußteils 1 (Fig. 1) angepaßt ist und mit diesen eine Schwalbenschwanzführung bildet. Die Nuten 24, 25 sind nach unten offen, so daß das Bedienteil 21 von oben auf die Schienen 8, 9 des Anschlußteils 1 aufgeschoben werden kann. Ferner sind die Nuten 24, 25 in ihren unteren Bereichen 26, 27 aufgeweitet, so daß das Aufsetzen des Bedienteils erleichtert wird. Das andere Gehäuseteil 23 trägt in an sich bekannter Weise Drucktasten 28 und nicht dargestellte Anzeigevorrichtungen. Eine weitere Druck taste 29 ist an der Seite des Bedienteils 21 vorgesehen und dient zum Ein- bzw. Ausschalten des Autoradios. Am oberen Ende der Nut 25 ist ein Mitnehmer 30 vorgesehen, der das Betätigungselement 17 (Fig. 1) bewegt, sobald sich das Bedienteil beim Aufschieben auf das Anschlußteil seiner Betriebsstellung nähert.

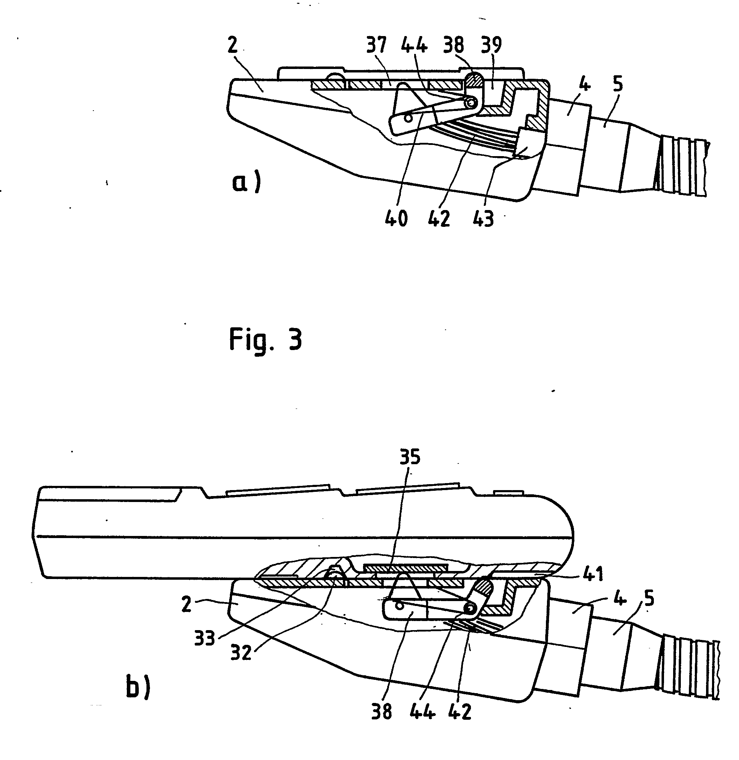

Die Enden der Nuten 24, 25 dienen als Anschlag für die Schienen 8, 9, so daß die Bewegung des Bedienteils 21 nach unten begrenzt wird. Außerdem wird das Bedienteil durch eine Rastvorrichtung fixiert. Diese Rastvorrichtung wird einerseits von einer Blattfeder 31, welche einstückig mit dem Gehäuseteil 2 verbunden ist und einen Rastnocken 32 trägt, und andererseits von einer Vertiefung 33 im Bedienteil 21 gebildet. Die elektrische Verbindung zwischen dem Bedienteil 21 und dem Anschlußteil 1 wird durch mehrere Kontaktpaare gebildet, wobei acht Kontakte 35 im Bedienteil derart angeordnet sind, daß sie über Aussparungen 34 zugänglich sind. Diese Kontakte 35 werden vorzugsweise von Leiterbahnen auf einer Leiterplatte gebildet, die auf der Innenseite des Gehäuseteils 22 aufliegt (Fig. 3b)).

Gegenstücke zu den Kontakten des Bedienteils 21 bilden Kontaktfedern 36, welche derart beweglich angeordnet sind, daß sie bei abgenommenem Bedienteil 21 nicht über die Oberfläche des Anschlußteils 1 hinausragen und bei aufgestztem Bedienteil an die Kontakte des Bedienteils angepreßt werden. Die Kontaktfedern 36 sind dazu auf dem einen Arm einer in Fig. 3 dargestellten Wippe 38 angeordnet, deren anderer Arm durch eine Öffnung 39 im Gehäuseteil 2 hinausragt. Der aus dem Gehäuse herausragende Teil der Wippe 38 ist übrigens in Fig. 1a) aufgebrochen dargestellt, um den Rastnocken 32 sichtbar zu machen.

Beim Aufsetzen des Bedienteils bleibt die Wippe zunächst in der in Fig. 3a) dargestellten Position, in welche sie durch eine Feder 40 gehalten wird. Erst wenn die Kante 41 des Bedienteils 21 den aus dem Anschlußteil 1 herausragenden Teil der Wippe 38 erreicht, wird dieser Teil in das Anschlußteil hineingedrückt, wodurch die Kontaktfedern 36 aus den Öffnungen 37 heraustreten und gegen die Kontakte 35 des Bedienteils 21 gepreßt werden, wie es in Fig. 3b) dargestellt ist. Die Kontaktfedern 36 sind an flexible Leitungen 42 eines Kabels 43, das im Schwanenhals 5 geführt wird, angeschlossen.

Auf der Rückseite des Bedienteils 21, also im Gehäuseteil 22, ist außerdem das Betätigungselement 43 eines Schiebeschalters angeordnet, welcher für seltener vorkommende Einstellungen vorgesehen ist. So kann beispielsweise mit dem Schiebeschalter eingestellt werden, ob die Betätigung der Drucktasten 28 durch einen Piepston quittiert werden soll.

## Ansprüche

1. Bedienteil für ein Autoradio, dadurch gekennzeichnet,
daß es mit einem in einem Auto eingebauten Anschlußteil (1) mit Hilfe einer leicht lösbaren Verbindungsvorrichtung verbindbar ist.

2. Bedienteil nach Anspruch 1, dadurch gekennzeichnet
daß am Bedienteil (21) und am Anschlußteil (1) Teile (8, 9, 24, 25) einer Schwalbenschwanzführung vorgesehen sind.

3. Bedienteil nach einem der Ansprüche 1 oder 2, dadurch gekennzeichnet,
daß die Teile der Schwalbenschwanzführung am Anschlußteil (1) durch zwei parallel verlaufende Schienen (8, 9) und die Teile am Bedienteil (21) durch zwei parallel verlaufende Nuten (24, 25) gebildet sind, wobei die Nuten (24, 25) an jeweils einem Ende offen sind.

4. Bedienteil nach einem der vorhergehenden Ansprüche, dadurch gekennzeichnet,
daß eine zwischen dem Bedienteil (21) und dem Anschlußteil (1) wirksame Rastvorrichtung (31 bis 33) vorgesehen ist.

5. Bedienteil nach Anspruch 4, dadurch gekennzeichnet,
daß die Rastvorrichtung von einer Vertiefung (33) im Bedienteil (21) und von einem Nocken (32) gebildet wird, welcher auf einer einstückig mit einem Gehäuseteil (2) des Anschlußteils (1) verbundenen Blattfeder (31) angeordnet ist.

6. Bedienteil nach einem der vorhergehenden Ansprüche, dadurch gekennzeichnet,
daß im Anschlußteil (1) ein Schalter vorgesehen ist, dessen Betätigungselement (17) aus dem Anschlußteil (1) derart herausragt, daß es von einem am Bedienteil (21) befindlichen Mitnehmer (30) beim Verbinden des Bedienteils (21) mit dem Anschlußteil (1) bewegt wird.

7. Bedienteil nach einem der vorhergehenden Ansprüche, dadurch gekennzeichnet,
daß das Bedienteil (21) Kontakte (35) aufweist, die über Aussparungen (34) im Gehäuse (22) des Bedienteils (21) zugänglich sind.

8. Bedienteil nach einem der Ansprüche 1 bis 6, dadurch gekennzeichnet,
daß im Anschlußteil (1) Kontaktfedern (36) vorgesehen sind, welche in das Anschlußteil (1) einschwenkbar sind, wenn das Bedienteil (21) nicht mit dem Anschlußteil (1) verbunden ist.

9. Bedienteil nach den Anspruchen 7 und 8, dadurch gekennzeichnet,
daß die Kontaktfedern (36) in die Aussparungen (34) eintreten, wenn das Bedienteil (21) mit dem Anschlußteil (1) verbunden ist.

10. Bedienteil nach Anspruch 8, dadurch gekennzeichnet,
daß die Kontaktfedern (36) auf einem ersten Arm einer Wippe (38) angeordnet sind und
daß eine Feder (40) die Wippe (38) derart belastet, daß das Ende eines zweiten Arms der Wippe (38) durch eine entsprechende Öffnung (29) aus dem Gehäuse (2) des Anschlußteils (1) herausragt.

11. Bedienteil nach Anspruch 8, dadurch gekennzeichnet,
daß die Kontaktfedern (36) winklig gebogene Drahtfedern sind.

12. Bedienteil nach einem der Ansprüche 8 bis 11, dadurch gekennzeichnet,
daß am Bedienteil (21) ein quer zur Längsrichtung der Nuten (24, 25) verlaufender Absatz (41) vorgesehen ist, der beim Zusammenfügen des Bedienteils (21) und des Anschlußteils (1) mit dem Ende des zweiten Arms der Wippe (38) in Wirkverbindung steht.

13. Bedienteil nach einem der vorhergehenden Ansprüche, dadurch gekennzeichnet,
daß das Anschlußteil (1) auf einem Schwanenhals (5) angeordnet ist.

Fig. 2

a)

b)

Fig. 1

a)

b)

EP 0 305 555 A1

R.-Nr. 1965

## Fig. 3

a)

b)

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 116 780 (AUDIO SYSTEMS INC.) * Seite 8, Zeile 15 - Seite 10, Zeile 19; Figuren 1,2 * --- | 1 | H 04 B 1/08 B 60 R 11/02 H 05 K 11/02 |
| A | DE-A-2 741 371 (SONY CORP.) * Seite 10, Zeile 4 - Seite 18, Zeile 17; Figuren 1-8 * --- | 3-5,7-9 | |
| A | DE-A-3 320 964 (LUTZ) * Seite 15, Zeile 14 - Seite 18, Zeile 21; Figuren 1-8 * --- | 3,6 | |
| A | US-A-3 993 278 (W.J. RACE) * Spalte 2, Zeile 45 - Spalte 4, Zeile 13; Figuren 1-3 * --- | 3-11 | |
| A | DE-A-2 906 088 (LICENTIA PATENT-VERWALTUNGS-GmbH) * Seite 4, Zeile 30 - Seite 6, Zeile 2; Figur 1 * --- | 2,6 | |
| E | EP-A-0 253 947 (GRUNDIG E.M.V.) * Spalte 2, Zeile 5 - Spalte 3, Zeile 30; Figuren 1-5 * ----- | 1 | RECHERCHIERTE SACHGEBIETE (Int. Cl.4) H 04 B H 05 K B 60 R |

Der vorliegende Recherchenbericht wurde für alle Patentansprüche erstellt

| Recherchenort | Abschlußdatum der Recherche | Prüfer |
|---|---|---|
| DEN HAAG | 16-05-1988 | DELANGUE P.C.J.G. |